# EUROPEAN PATENT APPLICATION

(11) **EP 4 436 205 A1**
(43) Date of publication of application: **25.09.2024**
(21) Application number: 22959830.5
(22) Date of filing: 27.09.2022
(51) Int. Cl.: H04R 1/10, H02J 7/00

(54) **DETECTION METHOD, ELECTRONIC DEVICE, AND READABLE STORAGE MEDIUM**

(71) Applicant: Shenzhen Shokz Co., Ltd., Shenzhen, Guangdong 518108 (CN)
(72) Inventor: LAI, Gan, Shenzhen, Guangdong 518108 (CN); HAN, Ruixin, Shenzhen, Guangdong 518108 (CN); WANG, Liang, Shenzhen, Guangdong 518108 (CN); TANG, Dongshan, Shenzhen, Guangdong 518108 (CN); WU, Jiahui, Shenzhen, Guangdong 518108 (CN)
(74) Representative: Wang, Bo
(86) International application number: PCT/CN2022/121746
(87) International publication number: WO 2024/065180

(57) **Abstract**

The present application discloses a detection method, an electronic device, and a readable storage medium. The detection method is used for detecting the states of wireless earphones and a charging box, a magnet is provided on the charging box, and magnetic sensors are provided on the wireless earphones. The detection method comprises: detecting whether detection signals of magnetic sensors are switched from a first state to a second state; detecting whether power receiving terminals of wireless earphones are electrically connected to a power supply terminal of a charging box; and in response to the fact that the detection signals are switched to the second state and the power receiving terminals are electrically connected to the power supply terminal, generating a boxing indication signal for indicating that the wireless earphones are placed into the charging box. According to the present application, it is detected whether the detection signals of the magnetic sensors are subjected to state switching, it is determined whether the wireless earphones are electrically connected to the charging box, and if it is determined that the detection signals are subjected to state switching, it is detected whether the states of the detection signals after switching are kept unchanged, so that the states of the wireless earphones and the charging box are accurately determined.

## Description

### TECHNICAL FIELD

The present disclosure relates to the technical field of portable listening devices, and in particular, to a method, an electronic device, and a readable storage medium for detection.

### BACKGROUND

With the increasing intelligence and portability of wireless earphones, the usage of the wireless earphones and charging cases is becoming more prevalent. The use of wireless earphones in conjunction with a charging case allows the earphones to be stored and charged via metal contact points in the charging case. This provides users with a longer battery life and a more intelligent usage experience.

In the existing technology, wireless earphones detect whether they are inside or outside the charging case by determining if an electrical connection has been established between the metal contact points of the earphones and the charging case. However, this method has several drawbacks. For example, poor contact between the metal contact points of the charging case and the earphones can result in incorrect detection of the earphones' state. Additionally, an abnormal working state of the charging case can also lead to incorrect detection of the state of the earphones.

### SUMMARY

The present disclosure provides at least a method, an electronic device, and a readable storage medium for detection to accurately determine the state of wireless earphones and an accompanying charging case thereof.

The first aspect of the present disclosure provides a method for detecting a state of a wireless earphone and a state of a charging case, wherein the charging case is provided with a magnet and the wireless earphone is provided with a magnetic sensor, the method comprising:
detecting whether a detection signal of the magnetic sensor switches from a first state to a second state; and
detecting whether a power-receiving terminal of the wireless earphone is electrically connected to a power-supply terminal of the charging case.

Optionally, the method further comprises:
in response to a determination that the detection signal switches to the second state and the power-receiving terminal is electrically connected to the power-supply terminal, generating an in-case indication signal indicating that the wireless earphone is in the charging case.

Optionally, the method further comprises:
in response to a determination that the detection signal switches to the second state and the power-receiving terminal is not electrically connected to the power-supply terminal, detecting whether the detection signal remains in the second state.

Optionally, the method further comprises:
in response to a determination that the detection signal doesn't remain in the second state, generating a not-in-case indication signal indicating that the charging case is not in the charging case.

Optionally, the method further comprises:
in response to a determination that the detection signal remains in the second state, generating a first fault indication signal.

Optionally, a step of detecting whether a detection signal of the magnetic sensor switches from a first state to a second state includes:
detecting whether a signal strength of the detection signal is greater than or equal to a preset strength threshold; and
in response to the signal strength being greater than or equal to the strength threshold, determining the detection signal is in the second state, and in response to the signal strength being less than the strength threshold, determining the detection signal is in the first state.

Optionally, the method further comprises:
in response to the first fault indication signal, detecting whether a wireless connection is established between the wireless earphone and the charging case;
in response to the wireless connection being established between the wireless earphone and the charging case, generating a third fault indication signal; and
in response to the wireless connection being not established between the wireless earphone and the charging case, generating a fourth fault indication signal.

Optionally, the magnetic sensor is a Hall sensor.

The second aspect of the present disclosure provides an electronic device comprising a memory and a processor that are mutually coupled, wherein the processor is configured to execute program instructions stored in the memory to implement a method for detection described above.

The third aspect of the present disclosure provides a non-transitory computer-readable medium, wherein the non-transitory computer-readable medium stores a computer program, and the computer program is capable of realizing a method for detection described above when executed by a processor.

The beneficial effects of the present disclosure include but not limited to: different from the prior art, the present disclosure obtains the detection signal of the magnetic sensor provided on the wireless earphone by a first processor of the wireless earphone, and determines whether the detection signal switches from the first state to the second state, at the same time the first processor determines whether the power-receiving terminal of the wireless earphone is electrically connected to the power-supply terminal of the charging case. The first processor, in response to a determination that the detection signal switches from the first state to the second state and the power-receiving terminal is electrically connected to a power-supply terminal, generates an in-case indication signal indicating that the wireless earphone is in the charging case; the first processor, in response to a determination that the detection signal switches to the second state and the power-receiving terminal is not electrically connected to the power-supply terminal, detects whether the detection signal remains in the second state, and generates a first fault indication signal if the detection signal remains in the second state, and generates a not-in-case indication signal indicating that the wireless earphone is not in the charging case if the detection signal does not remain in the second state. The present disclosure improves the detection accuracy of whether wireless earphones are in in the charging case or not and a working state of the charging case by judging a switching state of the detection signal of the magnetic sensor and judging whether the power-receiving terminal of the wireless earphone is electrically connected to the power-supply terminal of the charging case. The present disclosure helps avoid interference caused by external electromagnetic environments, poor contact between the metal contact points of the earphone and the charging case, and abnormal working conditions of the charging case, thereby enhancing the success rate of detecting the state of the wireless earphone.

It should be understood that the general description above and the detailed description that follows are exemplary and explanatory only and are not limited to the present disclosure.

### BRIEF DESCRIPTION OF THE DRAWINGS

In order to more clearly illustrate the technical solutions in the embodiments of the present disclosure, the following will briefly introduce the accompanying drawings that need to be used in the description of the embodiments, and it will be obvious that the accompanying drawings in the following description are only some of the embodiments of the present disclosure, and other attachments can be obtained according to them without giving creative labor to those with ordinary skill in the art.
FIG. 1 is a flowchart illustrating an exemplary embodiment of a method for detection according to the present disclosure;
FIG. 2 is a flowchart illustrating a specific flow of a step S11 in FIG. 1 according to the present disclosure;
FIG. 3 is a schematic diagram illustrating an exemplary frame of an embodiment of an electronic device of the present disclosure; and
FIG. 4 is a schematic diagram illustrating an exemplary frame of an embodiment of a computer-readable storage medium of the present disclosure.

### DETAILED DESCRIPTION

In order to enable those skilled in the art to better understand the technical solutions of the present disclosure, the method, the electronic device, and the readable storage medium for detection provided herein are described in further detail below in conjunction with the accompanying drawings and specific embodiments. It is to be understood that the described embodiments are only a part of the embodiments of the present disclosure, and not all of them. Based on the embodiments in the present disclosure, all other embodiments obtained by a person of ordinary skill in the art without making creative labor fall within the scope of protection of the present disclosure.

The terms "first", "second", etc. in the present disclosure are used to distinguish between different objects and are not used to describe a particular order. Additionally, the terms "comprising" and "including", and any variations thereof, are intended to cover non-exclusive objects. For example, a process, method, system, product, or apparatus comprising a series of steps or units is not limited to the listed steps or units, but optionally also includes steps or units that are not listed, or optionally also includes other steps or units inherent to those processes, methods, products, or devices.

Wireless earphones may be used in conjunction with electronic devices such as cell phones, laptops, watches, etc., to handle media, calls, and other audio services of the electronic devices, as well as other data services. The wireless earphones may be used in conjunction with the above mentioned electronic devices to provide various services to the user on the premise that the wireless earphones are removed from the earphone case by the user. The wireless function (e.g., Bluetooth function and wear detection function, etc.) needs to be detected in a timely manner when the wireless earphone is removed from the earphone case by the user. Similarly, when the wireless earphone is placed in the earphone case, the entry of the wireless earphone into the case needs to be detected in time for the wireless earphone to be turned off in time, henceforth saving power in the wireless earphone. This shows that the in/out detection of the wireless earphone is especially important for the wireless earphone.

Embodiments of the present disclosure provide a method for detecting a state of a wireless earphone and a state of a charging case. Specifically, by judging the state switching of the detection signal of the magnetic sensor and judging whether the power-receiving terminal of the wireless earphone is electrically connected to the power-supply terminal of the charging case, it is realized to judge the state of the wireless earphone in and out of the charging case and a working state of the charging case, so as to avoid external electromagnetic environment interference, interference brought by poor metal contact between the wireless earphone and the charging case and abnormality of the charging case and other scenarios, henceforth improving the success rate of detecting whether the wireless earphone is in and out of the charging case.

In some embodiments, the charging case to be detected in the present disclosure is provided with a second processor, a magnet, and a power-supply terminal, and the second processor is electrically connected to the power-supply terminal. The wireless earphone to be detected in the present disclosure is provided with a first processor, a magnetic sensor, and a power-receiving terminal, and the first processor is electrically connected to the magnetic sensor and the power-receiving terminal, respectively. Optionally, the magnetic sensor of this embodiment is specifically a Hall sensor. The magnetic sensor is used to generate a detection signal based on detecting a magnetic field around the wireless earphone, and the first processor is used to receive the detection signal from the magnetic sensor, and to determine whether or not the detection signal switches from a first state to a second state.

Specifically, when the wireless earphone is not in the charging case, the detection signal of the magnetic sensor is in the first state; when the wireless earphone is in the charging case, a magnet of the charging case changes the magnetic field around the wireless earphone, and at this time, the detection signal of the magnetic sensor switches from the first state to the second state.

Specifically, when the wireless earphone is in the charging case, the power-receiving terminal and the power-supply terminal are pressed against each other to realize an electrical connection. Specifically, the first processor may detect whether a current flowing through the power-receiving terminal is greater than a current threshold to determine whether the power-receiving terminal and the power-supply terminal is electrically connected; alternatively, the first processor may send an inquiry message to the second processor through the power-receiving terminal and the power-supply terminal, and then determine through a reply from the second processor whether the power-receiving terminal and the power-supply terminal is electrically connected.

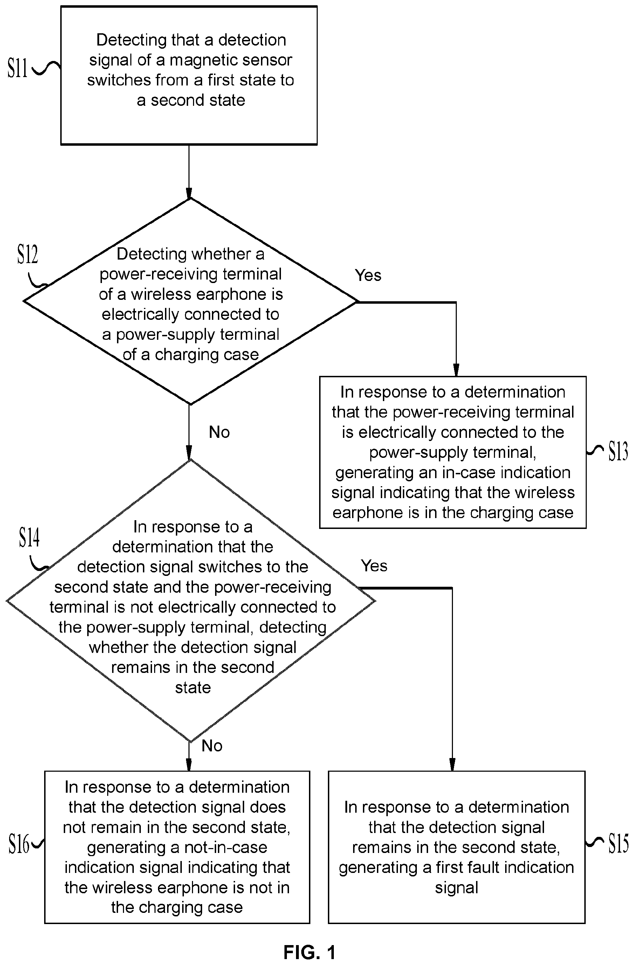

FIG. 1 is a flowchart illustrating an exemplary embodiment of a method for detection according to the present disclosure. Specifically, the method for detection in the present embodiment may include following steps.

In step S11, whether a detection signal of a magnetic sensor switches from a first state to a second state may be detected.

The magnetic sensor of the present embodiment correspondingly generates detection signals of different states by detecting changes in a magnetic field around a wireless earphone. Thus, when a first processor of the present embodiment detects that the detection signal switches from the first state to the second state, that is, it is judged that the magnetic field around the wireless earphone has changed, and such change may be caused by various reasons. It is necessary to further determine a reason for the change in the magnetic field.

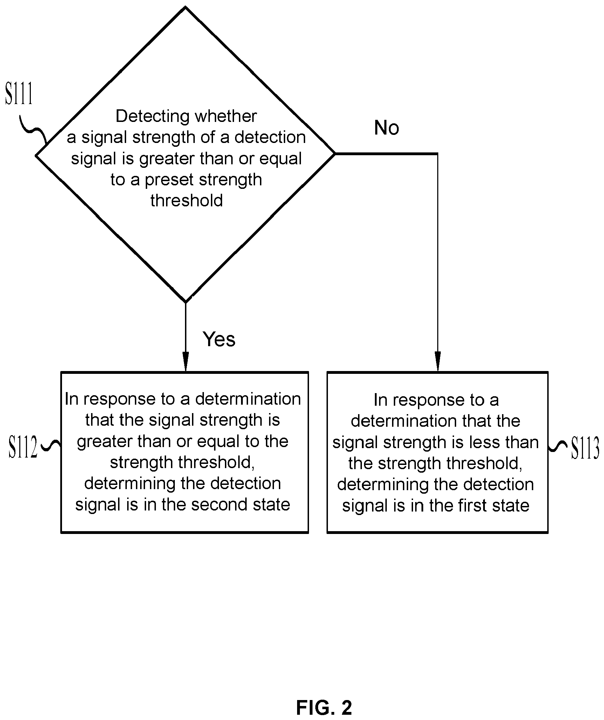

A process of specifically detecting whether the detection signal of the magnetic sensor switches from the first state to the second state is shown in FIG. 2, which is a flowchart illustrating a specific flow of the step S11 in FIG. 1. Specifically, following steps may be included.

In step 5111, whether a signal strength of the detection signal is greater than or equal to a preset strength threshold may be detected.

The magnetic sensor is a device that converts a magnetic signal into an electric signal. When the magnetic field around the magnetic sensor changes, a strength of a generated electric signal may also change. Therefore, it is possible to determine whether the detection signal is generated due to a switched state by comparing the signal strength of the detection signal generated by the magnetic sensor with the preset strength threshold. Optionally, the signal strength of the detection signal may specifically be denoted by a voltage amplitude or a current amplitude, etc.

Specifically, the strength threshold may be preset, and the strength threshold needs to be slightly greater than a signal strength of a detection signal generated by the wireless earphone when the wireless earphone is out of the charging case, i.e., when the magnetic sensor is not interfered with by other magnetic fields. When it is judged that the signal strength of the detection signal is greater than or equal to the strength threshold, step S 112 may be executed, and when it is judged that the signal strength of the detection signal is less than the strength threshold, step S 113 may be executed.

In step S112, in response to a determination that the signal strength is greater than or equal to the strength threshold, it may be determined that the detection signal is in the second state.

When the first processor detects that the signal strength is greater than or equal to the strength threshold, it may be determined that the detection signal has undergone a state switch, and a new magnetic field interference has occurred in the magnetic field around the wireless earphone, and the detection signal is in the second state at this time.

In step S113, in response to a determination that the signal strength is less than the strength threshold, it may be determined that the detection signal is in the first state.

When the wireless earphone is not in the charging case, the magnetic field around the wireless earphone may be regarded as an invariable and stable magnetic field. When the first processor detects that the signal strength is less than the strength threshold, it is judged that the detection signal has not undergone a state switch, and at this time, the detection signal is in the first state stably.

In step S12, whether the power-receiving terminal of the wireless earphone is electrically connected to the power-supply terminal of the charging case may be detected.

When the first processor determines that the detection signal switches from the first state to the second state, it may further detect whether the power-receiving terminal of the wireless earphone is electrically connected to the power-supply terminal of the charging case.

Specifically, the power-receiving terminal may be pressed against the power-supply terminal when the wireless earphone is in the charging case so as to form a circuit between the wireless earphone and the charging case. The first processor may detect a current value on the circuit, and if the current value is greater than a current threshold value, then it may be judged that the power-receiving terminal of the wireless earphone is electrically connected to the power-supply terminal of the charging case.

Alternatively, the wireless earphone may further be provided with a current-voltage conversion device between the first processor and the power-receiving terminal, so as to convert the current value on the circuit into a voltage value. The first processor may detect the voltage value, and if the voltage value is greater than a voltage threshold value, then it may be judged that the power-receiving terminal of the wireless earphone is electrically connected to the power-supply terminal of the charging case.

Alternatively, the first processor may send an inquiry message to the second processor through the power-receiving terminal and the power-supply terminal, and when the second processor sends a reply message to the first processor through the power-receiving terminal and the power-supply terminal, it may be determined that the power-receiving terminal of the wireless earphone is electrically connected to the power-supply terminal of the charging case.

Optionally, when the first processor determines that the power-receiving terminal is electrically connected to the power-supply terminal of the charging case, step S13 may be executed, and when the first processor determines that the power-receiving terminal is not electrically connected to the power-supply terminal of the charging case, step S14 may be executed.

In step S13, in response to a determination that the power-receiving terminal is electrically connected to the power-supply terminal, an in-case indication signal indicating that the wireless earphone is in the charging case may be generated.

The first processor may judge that the detection signal switches from the first state to the second state according to the step S11, and judge that the power-receiving terminal is electrically connected to the power-supply terminal according to the step S12, then the first processor may judge that the wireless earphone is in the charging case and generate the in-case indication signal indicating that the wireless earphone is in the charging case.

In step S14, in response to a determination that the detection signal switches to the second state and the power-receiving terminal is electrically connected to the power-supply terminal, whether the detection signal remains in the second state may be detected.

The first processor may judge that the detection signal switches from the first state to the second state according to the step S11, and judge that the power-receiving terminal is not electrically connected to the power-supply terminal according to the step S12, at which time the first processor may need to further judge whether the detection signal remains in the second state.

Specifically, the first processor may obtain a detection signal through the magnetic sensor again, compare the detection signal obtained from this detection with the detection signal detected for the first time, and determine, through a secondary judgment of the detection signal, whether the power-receiving terminal being not electrically connected to the power-supply terminal is caused by an abnormal working state of the charging case.

Optionally, when the first processor judges that the detection signal remains in the second state, step S15 may be executed, and when the first processor judges that the detection signal does not remain in the second state, step S16 may be executed.

In step S15, in response to a determination that the detection signal remains in the second state, a first fault indication signal may be generated.

When the first processor determines that the detection signal remains in the second state through the secondary judgment of the detection signal, the first fault indication signal indicating that the charging case is in an abnormal working state may be generated. Specifically, the first fault indication signal may indicate that a metal contact between the wireless earphone and the charging case is poor. Specifically, the poor contact may be that the power-receiving terminal on the wireless earphone is abnormal, or that the power-supply terminal on the charging case is abnormal, or that the contact between the power-receiving terminal and the power-supply terminal is abnormal.

In step S16, in response to a determination that the detection signal does not remain in the second state, a not-in-case indication signal indicating that the wireless earphone is not in the charging case may be generated.

When the first processor judges that the detection signal does not remain in the second state through the secondary judgment of the detection signal, the not-in-case indication signal indicating that the wireless earphone is not in the charging case may be generated.

Specifically, in response to the not-in-case indication signal indicating that the wireless earphone is not in the charging case, the first processor may judge that the wireless earphone is in an out-of-case state. At the same time, the first processor may judge that the switch state of the detection signal is caused by the wireless earphone receiving external electromagnetic interference. Optionally, when the first processor judges that the wireless earphone receives the external electromagnetic interference, normal communication between the wireless earphone and the charging case may be maintained.

The method for detection according to the embodiments of the present disclosure realizes accurately determining whether the wireless earphone is in the charging case or not and the working state of the charging case by judging a switching state of the detection signal of the magnetic sensor and judging whether the power-receiving terminal of the wireless earphone is electrically connected to the power-supply terminal of the charging case, which avoids interference caused by external electromagnetic environments, poor contact between the metal contact points of the earphone and the charging case, and abnormal working conditions of the charging case, thereby enhancing the success rate of detecting the state of the wireless earphone.

Optionally, in some embodiments, the first processor may execute step S11 and step S12 simultaneously, and may directly execute step S21 to step S23 after the first processor judges that the detection signal switches from the first state to the second state and that the power-receiving terminal of the wireless earphone is electrically connected to the power-supply terminal of the charging case, and generates the in-case indication signal indicating that the wireless earphone is in the charging case.

In step S21, in response to the in-case indication signal, the charging case may be controlled to charge the wireless earphone.

The first processor may transmit the in-case indication signal to the second processor through the power-receiving terminal and the power-supply terminal that are electrically connected for controlling the charging case to charge the wireless earphone through the second processor.

In step S22, whether the detection signal is in the second state may be detected after the charging case charges the wireless earphone for a preset time.

As the magnet in the charging case continuously affects the magnetic field around the wireless earphone when the wireless earphone is in the charging case, and an energy of the magnet affecting the magnetic field remains unchanged, the detection signal may always remain in the second state after switching from the first state to the second state.

Thus, after the charging case charges the wireless earphone for the preset time, the first processor detects whether the detection signal is in the second state, and if it detects that the detection signal remains in the second state, it may determine that both the charging case and the wireless earphone are in a normal working state; and if it is detected that the detection signal is not in the second state, then step S23 may be further executed.

In step S23, in response to a determination that the detection signal is not in the second state, a second fault indication signal may be generated.

Since the charging case charges the wireless earphone for a certain time, then it may be determined that there is no abnormality in an electrical connection between the charging case and the wireless earphone, and the second processor of the charging case may normally recognize the in-case indication signal output by the first processor of the wireless earphone. Thus, when the first processor detects that the detection signal is not in the second state (i.e., it is proved that the detection signal detected by the first processor is abnormal), the second fault indication signal may be generated. Specifically, the second fault indication signal may indicate that there is a processing abnormality in the first processor or an abnormality in the magnetic sensor that causes an abnormality in a detected detection signal.

Optionally, in some embodiments, the first processor may execute the step S11 and the step S12 simultaneously, and may directly execute step S31 to step S32 as described below after the first processor determines that the detection signal switches from the first state to the second state, the power-receiving terminal of the wireless earphone is electrically connected to the power-supply terminal of the charging case, and the in-case indication signal indicating that the wireless earphone is in the charging case is generated.

In step S31, a power query message may be sent.

Upon receiving the in-case indication signal, the second processor further sends the power query message to the first processor, and determines a power level of the wireless earphone in a current state based on a reply message of the first processor.

Optionally, when the power level of the wireless earphone in the current state is judged to be less than being fully charged, the step S32 may be executed, and when the power level of the wireless earphone in the current state is judged to be fully charged, the step S33 may be executed.

In step S32, in response to a determination that the power of the wireless earphone is not fully charged, the charging case may be controlled to charge the wireless earphone.

When the second processor judges that the wireless earphone in the current state is not fully charged (i.e., it is demonstrated that the wireless earphone needs to be charged), the second processor may control a charging assembly to charge the wireless earphone.

In step S33, in response to a determination that the wireless earphone is fully charged, the charging case may be controlled to stop charging.

When the second processor judges that the power level of the wireless earphone in the current state is fully charged (i.e., it is demonstrated that the wireless earphone does not need to be charged), the second processor may control the charging assembly to stop working.

Optionally, in some embodiments, after the first processor generates the first fault indication signal, the present embodiment may further execute step S41 and step S42, or step S41 and step S43 described below, to further determine a reason for the abnormality of the charging case.

In step S41, in response to the first fault indication signal, whether a wireless connection is established between the wireless earphone and the charging case may be detected.

In response to the first fault indication signal, it may be further detected whether the wireless connection is established between the wireless earphone and the charging case, and specifically, the first processor may send a first communication message to the second processor based on a wireless network, and further judge whether a second communication message replied by the second processor based on the first communication message is received.

In step S42, in response to a determination that the wireless connection is not established between the wireless earphone and the charging case, a third fault indication signal may be generated.

When the first processor receives the second communication message replied by the second processor based on the first communication message, it may be determined that the wireless connection is established between the wireless earphone and the charging case, and the third fault indication signal may be generated. Specifically, the third fault indication signal may indicate that the charging case is in a power insufficiency state.

Further, the first processor may further produce a third communication message based on the second communication message, and send the third communication message and the third fault indication signal to the second processor, so as to enable the second processor to confirm that the wireless connection is established between the wireless earphone and the charging case based on the third communication message; and may control a relevant indicator light of the charging case to light up based on the third fault indication signal, so as to remind a user of an abnormal working state of the charging case.

In step S43, in response to a determination that the wireless connection fails to be established between the wireless earphone and the charging case, a fourth fault indication signal may be generated.

When the first processor does not receive the second communication message replied by the second processor based on the first communication message, it may be determined that the wireless connection between the wireless earphone and the charging case fails to be established, and the fourth fault indication signal may be generated. Specifically, the fourth fault indication signal may indicate that a program of the second processor of the charging case is in disarray.

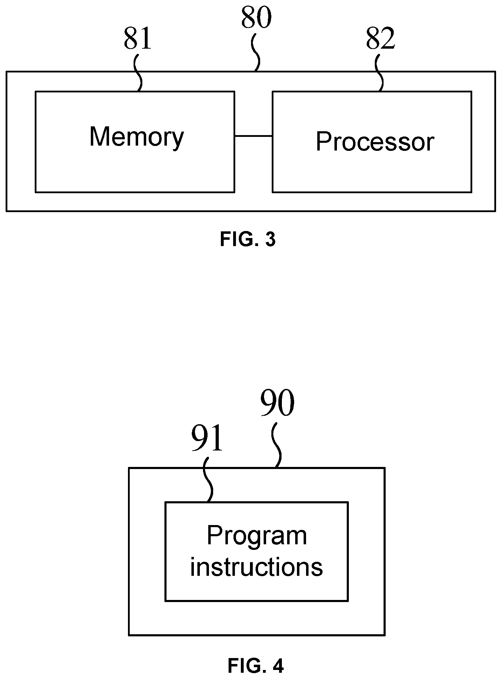

The present disclosure also provides an electronic device, please refer to FIG. 3. FIG. 3 is a schematic diagram illustrating an exemplary frame of an embodiment of an electronic device of the present disclosure. As shown in FIG. 3, an electronic device 80 may include a memory 81 and a processor 82 that are coupled to each other, and the processor 82 may be used to execute program instructions stored in the memory 81 to realize step(s) in any of the above-mentioned method for detection. In a specific embodiment scenario, the electronic device 80 may include, but is not limited to: a microcomputer, a server, and in addition, the electronic device 80 may include a mobile device such as a laptop, a tablet, or the like, which is not limited herein.

Specifically, the processor 82 may be used to control itself and the memory 81 to implement the step(s) in any of the above embodiments of the method for detection. The processor 82 may be referred to as a Central Processing Unit (CPU). The processor 82 may be an integrated circuit chip with signal-processing capabilities. The processor 82 may be a general-purpose processor, a Digital Signal Processor (DSP), an Application Specific Integrated Circuit (ASIC), a Field-Programmable Gate Array (FPGA) or other programmable logic devices, discrete gate or transistor logic devices, and discrete hardware components. The general-purpose processor may be a microprocessor or the processor may be any conventional processor, etc. Alternatively, the processor 82 may be co-implemented by the integrated circuit chip.

The present disclosure also provides a computer-readable storage medium, please refer to FIG. 4. FIG. 4 is a schematic diagram illustrating an exemplary frame of an embodiment of a computer-readable storage medium of the present disclosure. As shown in FIG. 4, a computer-readable storage medium 90 may store program instructions 91 capable of being run by a processor, and the program instructions 91 may be used to implement the step(s) in any of the above-described embodiments of the method for detection.

In some embodiments, a device provided by embodiments of the present disclosure has a function or contains a module that can be used to perform the method described in the embodiments above, the specific implementation of which can be referred to the description of the embodiments above, and which will not be repeated herein for brevity.

The description of the various embodiments above tends to emphasize the differences between the various embodiments, and the similarities or likenesses can be cross-referenced, and will not be repeated herein for the sake of brevity.

In the several embodiments provided in the present disclosure, it should be understood that the methods and devices disclosed, may be realized in other ways. For example, the above-described embodiments of the device are merely schematic, e.g., the division of a module or a unit is merely a logical functional division, and the actual implementation can be divided in another way, e.g., the unit or component can be combined or can be integrated into another system, or some features can be ignored, or not implemented. Besides, the coupling or direct coupling or communication connection between each other shown or discussed can be indirect coupling or communication connection through some interface, device, or unit, which can be electrical, mechanical, or otherwise.

Alternatively, the various functional units in various embodiments of the present disclosure may be integrated in a single processing unit, or the individual units may be physically present individually, or two or more units may be integrated into a single unit. The above integrated units can be implemented either in the form of hardware or in the form of software functional units.

Integrated units may be stored on a computer-readable storage medium if implemented as software function units and sold or used as stand-alone products. Based on this understanding, the technical solution of the present disclosure may be embodied essentially or in part as a contribution to the prior art, or all or part of the technical solution may be embodied in the form of a software product, which is stored in a storage medium and comprises a number of instructions for causing a computer device (which may be a personal computer, a server or a network device, etc.) or a processor to perform all or part of the steps of the methods of the various embodiments of the present disclosure. The aforementioned storage media include a USB flash drive, a removable hard disk, a read-only memory (ROM), a random access memory (RAM), a disk or a CD, and other media that can store program code.

The above is only an example of the present disclosure and is not intended to limit the scope of the present disclosure, and any equivalent structure or equivalent process transformations utilizing the contents of the present disclosure and the accompanying drawings, or directly or indirectly applying them in other related technical fields, are included in the scope of patent protection of the present disclosure.

## Claims

1. A method for detecting a state of a wireless earphone and a state of a charging case,
wherein the charging case is provided with a magnet and the wireless earphone is provided with a magnetic sensor, the method comprising:
detecting whether a detection signal of the magnetic sensor switches from a first state to a second state; and
detecting whether a power-receiving terminal of the wireless earphone is electrically connected to a power-supply terminal of the charging case.

2. The method of claim 1, further comprising:
in response to a determination that the detection signal switches to the second state and the power-receiving terminal is electrically connected to the power-supply terminal, generating an in-case indication signal indicating that the wireless earphone is in the charging case.

3. The method of claim 1, further comprising:
in response to a determination that the detection signal switches to the second state and the power-receiving terminal is not electrically connected to the power-supply terminal, detecting whether the detection signal remains in the second state.

4. The method of claim 3, further comprising:
in response to a determination that the detection signal doesn't remain in the second state, generating a not-in-case indication signal indicating that the charging case is not in the charging case.

5. The method of claim 3, further comprising:
in response to a determination that the detection signal remains in the second state, generating a first fault indication signal.

6. The method of claim 1, wherein the detecting whether a detection signal of the magnetic sensor switches from a first state to a second state includes:
detecting whether a signal strength of the detection signal is greater than or equal to a preset strength threshold; and
in response to the signal strength being greater than or equal to the strength threshold, determining the detection signal is in the second state, and in response to the signal strength being less than the strength threshold, determining the detection signal is in the first state.

7. The method of claim 5, further comprising:
in response to the first fault indication signal, detecting whether a wireless connection is established between the wireless earphone and the charging case;
in response to the wireless connection being established between the wireless earphone and the charging case, generating a third fault indication signal; and
in response to the wireless connection being not established between the wireless earphone and the charging case, generating a fourth fault indication signal.

8. The method of claim 1, wherein the magnetic sensor is a Hall sensor.

9. An electronic device, comprising a memory and a processor that are mutually coupled, wherein the processor is configured to execute program instructions stored in the memory to implement a method for detection of any one of claims 1-8.

10. A non-transitory computer-readable medium, wherein the non-transitory computer-readable medium stores a computer program, and the computer program is capable of realizing a method for detection of any one of claims 1-8 when executed by a processor.
